# EUROPEAN PATENT APPLICATION

(11) **EP 4 084 592 A1**
(43) Date of publication of application: **02.11.2022**
(21) Application number: 21275048.3
(22) Date of filing: 29.04.2021
(51) Int. Cl.: H05K 7/14

(54) **ELECTRONICS UNIT**

(71) Applicant: MBDA UK Limited, Stevenage, Hertfordshire SG1 2DA (GB)
(72) Inventor: The designation of the inventor has not yet been filed
(74) Representative: BAE SYSTEMS plc Group IP Department

(57) **Abstract**

An electronic unit for a missile comprising a potted electronics in a housing; the unit being adapted to compensate for a difference in coefficient of thermal expansion between the potted electronics and the housing, the unit further comprising; a first ramp; and a second ramp slidably arranged against the first ramp, wherein the first and second ramps are disposed within the housing, the first or the second ramp abutting the potted electronics so as to provide an interference fit between the potted electronics and the housing; wherein the first ramp and second ramp each comprise a coefficient of thermal expansion selected to maintain the interference fit between the potted electronics and the housing throughout a temperature range.

## Description

### FIELD

This invention relates to an electronics unit, in particular, an electronics unit for a missile.

### BACKGROUND

Missiles contain electronics units which may comprise fragile components. Missiles also tend to operate in extreme temperature ranges and may change temperature rapidly during use. Within an electronics unit, electronics are commonly 'potted' in a potting compound to protect the fragile components from shock forces and rapid temperature changes. Said potted electronics are retained within a housing. The housing may be fabricated from a material having a different coefficient of thermal expansion to that of the potting compound. When subject to changing temperatures, therefore, the housing of the electronics may expand at a different rate compared to the potted electronics. This may yield temperature induced gaps between the potted electronics and the housing, or alternatively result in compression of the potted electronics. During operational use, the missile may be subject to vibration on an aircraft weapon pylon; or to high acceleration events such as launch or target impact. Any gaps may allow the potted electronics to vibrate or move within the housing and this movement may destroy or damage the electronics, consequently impairing the function of the missile.

It is an example aim of the present invention to solve or avoid such problems associated with temperature induced movement in potted electronics in missiles.

### SUMMARY OF INVENTION

According to a first aspect, there is provided an electronic unit for a missile comprising a potted electronics in a housing; the unit being adapted to compensate for a difference in coefficient of thermal expansion between the potted electronics and the housing, the unit further comprising; a first ramp; and, a second ramp slidably arranged against the first ramp, wherein the first and second ramps are disposed within the housing, the first or the second ramp abutting the potted electronics so as to provide an interference fit between the potted electronics and the housing; wherein the first ramp and second ramp each comprise a coefficient of thermal expansion selected to maintain the interference fit between the potted electronics and the housing throughout a temperature range.

During high acceleration events such as impact of the missile onto a target (which may yield forces in excess of 100,000 G), the electronics unit may still be required to function to enable correct operation of the missile, for example where delayed fuse initiation is used for armour piercing or bunker busting weapons.

Potting electronics reduces the chance of shear forces acting on the individual electronic components. Shear forces may sever or damage connections between components, for example solder joints between printed circuit boards. Such potting compounds may be semi rigid or gelatinous. The potting compound may be selected from a group comprising thermosetting plastics, silicone rubber gels or epoxy based resins. Preferably the electronics are set in an epoxy resin. More preferably, the electronics are set in Eccobond^{™}45 provided by Henkel^{®}.

The potted electronics are retained within the housing. Said housing may be a walled structure arranged to protect the potted electronics. The housing may be of any suitable shape to retain the potted electronics. Preferably, the housing is in the form of a generally cylindrical container comprising a side wall and two end faces accommodating the potted electronics. Of course, the housing may have other geometries or shapes so as to fit within the general construction of the missile. For example, the housing may have a square, rectangular, circular or irregular cross section. The housing may be made from metal, metal alloys, metalloids or other non-metal high strength materials. The housing may be made from the same material as the body of a missile in which the unit is placed. Preferably, the housing comprises a low density in order to minimise inertial forces of the housing during high acceleration events. Preferably the housing is made from a low density metal such as aluminium. More preferably, the housing is made from aluminium 2014A.

There may be a mismatch between the coefficients of thermal expansion (CTEs) of the housing and the potted electronics. Temperature changes during operational use of the missile, commonly in the range from -50°C to +100°C, may, as a result, create temperature induced gaps between the potted electronics and the housing. Such gaps have the potential to prevent the missile functioning as intended as the potted electronics may begin to vibrate and move freely within the temperature induced gap within the housing. This movement may be extremely amplified during a high acceleration event, and may result in damage or destruction of the potted electronics. Conversely, in cold temperatures, the housing may contract faster than the potted electronics thereby stressing the potted electronics. Such stresses may also damage the electronic components within the potted electronics.

Advantageously, the present inventors have found that the provision of a first and second ramp, together a 'ramp arrangement', disposed within the housing can be used to compensate for the mismatch in CTE between the housing and the potted electronics. Therefore, the provision of the ramp arrangement may increase the probability that the missile will function correctly in operational use throughout a temperature range.

In the present invention, the first ramp and second ramp are disposed within the housing and are slidably arranged against each other wherein the first or second ramp is abutted against the potted electronics to create an interference fit between the potted electronics and the housing. Preferably, the first and second ramp comprise a face at an angle in the range of from 30 to 60° relative to the roll axis of the missile, more preferably at an angle of 45° relative to the roll axis of the missile i.e. both the first and second ramp mate on a 45° interface.

The coefficients of thermal expansion of the first and second ramp are selected to maintain the interference fit between the potted electronics and the housing throughout a temperature range. The first and second ramp may not have the same coefficient of thermal expansion. The coefficient of thermal expansion may be selected according to the specific needs of the electronics unit taking into account, for example, the material selection of the potting compound and housing. For example, it may be necessary to calculate the expected maximum and minimum axial length of a temperature induced gap over an expected temperature range based upon the materials used. Once this value has been determined, the material of the first and second ramp may be selected so that the difference in their respective coefficients of thermal expansion is such that first and second ramp may effectively 'absorb' this temperature induced gap by volumetric expansion across the same given temperature range.

Preferably, and in order to accommodate a difference in coefficient of thermal expansion, the first ramp and second ramp are made of different materials.

The second ramp may be made from any material which does not comprise a coefficient of thermal expansion exactly of the same value as the first ramp.

The electronics unit will now be explained with reference to a change in temperature arising during operational use of the missile.

The housing comprises a first ramp slidably arranged against a second ramp and a potted electronics component wherein the first and second ramp cause the potted electronics component to be in an interference fit with the housing.

As the electronics unit cools from a relatively hot state, the housing contracts less than the potted electronics due to the housing comprising a lower coefficient of thermal expansion. This may create a temperature induced gap between the walls of the housing and the potted electronics. However, the first and second ramps contract at different rates due to the difference in their coefficients of thermal expansion. As the first and second ramps are bounded by the housing, the difference in rate of contraction forces the first ramp to ride up the second ramp. The axial length inhabited by the first and second ramp arrangement is thereby increased. This increase in axial length compensates for the temperature induced gap that would otherwise be created by the differential contraction of the housing and the potted electronics.

Conversely, as the electronics unit heats from a relatively cold state, the housing expands less than the potted electronics. In addition, the first and second ramps expand by different amounts due to a difference in their relative coefficients of thermal expansion. As a result, the first ramp slides down the second ramp, reducing the axial length inhabited by the first and second ramp arrangement and compensating for the different amounts by which the housing and potted electronics expand.

Wherein the interface between the first and second ramp defines an angle, the present inventors have found advantageously that said interface may be configured to translate shocks along a longitudinal axis of the missile through the angle into the housing thereby isolating the potted electronics. The present inventors have found that that the provision of a ramp arrangement in addition to compensating for temperature induced gaps may also aid in translating shock forces which enter the missile. Such shock forces may enter the missile from the first point of impact, i.e. the tip of the missile along the axis of the missile before being translated through an angle defined by the interface of the first and second ramp such as to create a lateral component of the force vector into the housing thereby preventing the total shock force from being transmitted directly into the potted electronics. For example, where the interface between the first and second ramp is 45°, incoming shock forces along the axis of the missile are translated 90° into the housing i.e. the axial force vector is converted nearly wholly into a lateral force vector thereby avoiding the potted electronics.

The present inventors believe this feature actively protects the potted electronics from damage during high acceleration events.

In one arrangement, the first ramp is a toroid and the second ramp is cone shaped. In this arrangement, the unit may be further arranged such that the first and second ramp are concentrically arranged such that the toroid is slidaby mounted on the cone.

The operational temperature range wherein the electronic unit functions may be in the range of from -60°C to 100°C.

Optionally, at least one of the first or second ramps is integral to the housing. For example, the second ramp may take the form of a cone shaped protrusion on one axial face of the housing. This may be advantageous in reducing the manufacturing and assembly complexity of the electronics unit and may further eliminate any further sources of temperature induced gaps within the housing.

Optionally, the first or second ramp angle profile may be tailored to ensure abutment of the first or second ramp to the potted electronics throughout the temperature range. For example, the ramp angle profile may be linear or non-linear. Where the ramp angle profile is linear, i.e. there is a constant angle difference between the first and second ramp e.g. 45°, the axial length of the ramp arrangement will change linearly with the differing expansion of the first and second ramps. Conversely, where the ramp angle profile is non-linear, i.e. the profile between the first and second ramp appears as a curve or waveform or anything other than a constant angle, the axial length of the ramp arrangement will change non-linearly with the differing expansion of the first and second ramps. A non-linear ramp angle profile may be advantageous where sudden temperature changes require the ramp arrangement to change axial length quickly, i.e. the gradient of the ramp will be steep. It may also be advantageous to have shallow gradient portions on the ramp angle profile in order for the ramp arrangement to temporarily change axial length slowly. Preferably, the ramp angle profile is linear.

The electronics unit may further comprise a compressible membrane arranged between the first or second ramp and the potted electronics. The compressible membrane may further aide in the isolation of the potted electronics within the housing. For example, the electronics may be assembled under an interference fit with the housing wherein a compressible membrane is provided between the potted electronics and the housing in order to eliminate extremely small tolerance gaps created during manufacture. Furthermore, the compressible membrane may further be arranged to cocoon or envelop the potted electronics, i.e. surrounding it on all sides within the housing. The compressible membrane may be made from an elastomer. Preferably the compressible membrane is made from rubber.

In one arrangement, the first ramp may comprise a coefficient of thermal expansion in the range of from 75 to 130 x 10⁻⁶*m*/*mK.* Preferably in the range of from 110 to 125 x 10⁻⁶*m*/*mK.*

In one arrangement, the second ramp may comprise a coefficient of thermal expansion in the range of from 10 to 30 x 10⁻⁶*m*/*mK.* Preferably in the range of from 20 to 25 x 10⁻⁶*m*/*mK.*

There may be a provided a plurality of ramp arrangements within the electronics unit. For example, the provision of two identical ramp arrangements disposed either side of a potted electronics component may be advantageous where there is expected a large temperature induced gap during operation use of the electronics unit.

The electronics unit may be a safe arm unit for a missile.

The invention extends to a missile comprising the electronics unit of the first aspect. The missile may comprise a plurality of electronics units as herein defined. The missile may be air launched, ground launched or sea launched.

According to a third aspect, there is provided a method for designing an electronics unit according to the first aspect comprising the steps of:
selecting coefficients of thermal expansion of the first and second ramps based upon: the coefficient of thermal expansion of the potted electronics and the housing to ensure the first or second ramp abuts the potted electronics so as to provide the interference fit between the potted electronics and the housing throughout the temperature range.

### FIGURES

Several arrangements of the invention will now be described by way of example and with reference to the accompanying drawings of which;-
Figures 1a & 1b show an example arrangement of the device.
Figure 2 shows a force diagram of the example arrangement of Figure 1a.
Figure 3 shows a missile comprising the device.

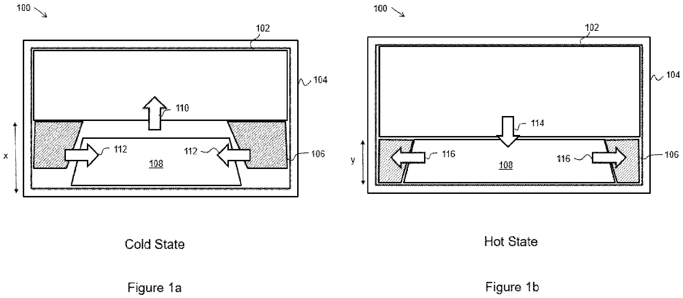

Figure 1a & 1b show an example of the electronics unit 100 according to an embodiment of the invention, respectively in a cold temperature and a hot temperature state. The unit 100 comprises a potted electronics 102 in a housing 104. The unit 100 is adapted to compensate for a difference in coefficient of thermal expansion between the potted electronics 102 and the housing 104, the unit further comprising a first ramp 106 and a second ramp 108 slidably arranged against the first ramp 106. Both the first and second ramps are disposed within the housing 104 wherein the first ramp 106 or the second ramp 108 abuts the potted electronics 102 so as to provide an interference fit between the potted electronics 102 and the housing 104. The first ramp 106 and second ramp 108 each comprise a coefficient of thermal expansion selected to maintain the interference fit between the potted electronics and the housing throughout a temperature range.

In the present arrangement, the electronics are potted in Eccobond 45^{™} to form the potted electronics 102. The housing is an aluminium housing in the form of a hollow cylindrical container. As the housing 104 comprises a coefficient of thermal expansion lesser than the potted electronics 102, there is a mismatch in CTE, and the housing 104 expands to a lesser extent than the potted electronics 102.

In the present arrangement, the first ramp 106 is a toroid concentrically mounted on the second ramp 108 which is a cone. The first ramp 106 is made from acetal having a CTE of 120 x 10⁻⁶*m*/*mK.* The second ramp 108 is made from aluminium 2014A having a CTE of 23 x 10⁻⁶*m*/*mK.* In this example, the first ramp comprises a CTE greater than the second ramp, and so the first ramp will expand or contract to a greater extent than the second ramp.

Whilst in this example the first ramp 106 is made from acetal and the second ramp 108 is made from aluminium 2014A, it may be appreciated that the exact material selection of the first ramp 106 and second ramp 108 may be selected according to the maximum and minimum axial length of an expected temperature induced gap. As such, the first and second ramp may be made from a group of materials comprising metal, metal alloys, metalloids, polymers such as nylon, isoprene, polypropelene, polyoxymethylene (Delrin^{®}) or hydroxyacetone (acetal). Preferably, the first ramp is made from a polymer. More preferably, the first ramp is made from polyoxymethylene (Delrin^{®}). Preferably, the second ramp is made from aluminium. More preferably, the second ramp is made from aluminium 2014A.

As the temperature cools, the potted electronics 102 contracts thereby vacating a volume to create a temperature induced gap indicated by arrow 110 in Figure 1a. The first ramp 106 contracts more than the second ramp 108 as indicated by arrows 112. As the first ramp 106 contracts, it exerts a compressive force on the second ramp 108, which is resolved into a linear force by sliding against the second ramp 108. It can be seen that the axial length of the ramp arrangement is extended, pushing into the temperature induced gap vacated by the potted electronics 102. The ramp arrangement thus exerts a securing force against the potted electronics 102, preventing vibration and unwanted movement of the potted electronics 102 within the housing 104 and maintaining an interference fit between the potted electronics 102 and housing 104.

Conversely, as the temperature increases, the first ramp 106 expands more than the second ramp 108 as indicated by arrows 116. The compression of the first ramp on the cone of the second ramp 108 is released. As the potted electronics expand to push against the ramp arrangement, the first ramp 106 therefore slides against the second ramp 108, reducing the axial length of the ramp arrangement.

It can therefore readily be seen that the ramp arrangement (first ramp 106 and second ramp 108) changes its axial length in a cold temperature state indicated by distance x in Figure 1a versus the axial length in a hot temperature state indicated by distance y in Figure 1b.

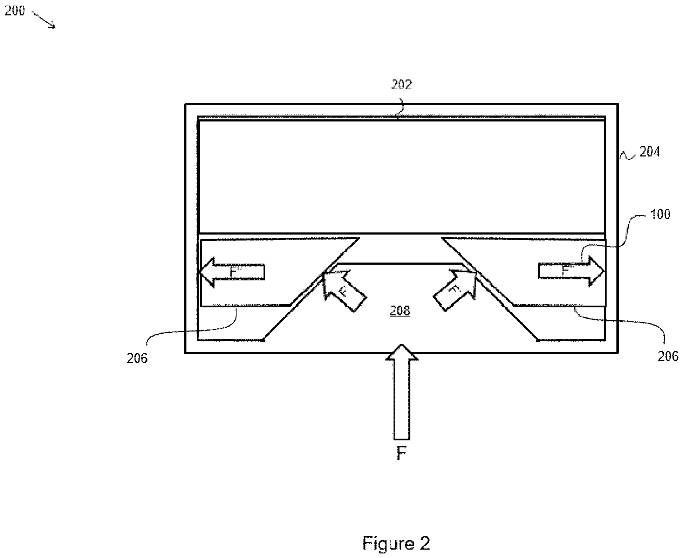

Turning to Figure 2, there is provided a force diagram of an electronics unit 200 undergoing a high acceleration event indicated by Force F. In this arrangement, the electronics unit 200 oriented within the missile (not shown) such that the axis of roll of the missile is collinear with force vector F. In this arrangement, the second ramp 208 is integral to the housing 204, i.e. it is machined from a single body. In this arrangement, the interface between the first ramp 206 and second ramp 208, i.e. the ramp angle profile is linear and at 45°.

In this example, Force F is a force resulting from impact of the missile onto a target. Force F is directly transmitted through the housing 204 to the second ramp 208 as they are integral. The second ramp 208 is slidably mounted against the first ramp 206 therefore the Force F is translated through 45° defined by the ramp angle profile (45°) to become Force F'. The first ramp 206 is also abutted against the housing 204 therefore Force F' is further translated through another 45° into Force F". Force F" in turn acts against the side walls of the housing 204. Incoming Force F is therefore translated through 90° thereby converting the incoming impact force from a wholly axial force vector into a wholly lateral force. Force F is therefore not transmitted into the potted electronics 202. The arrangement thereby protects said electronics from damage.

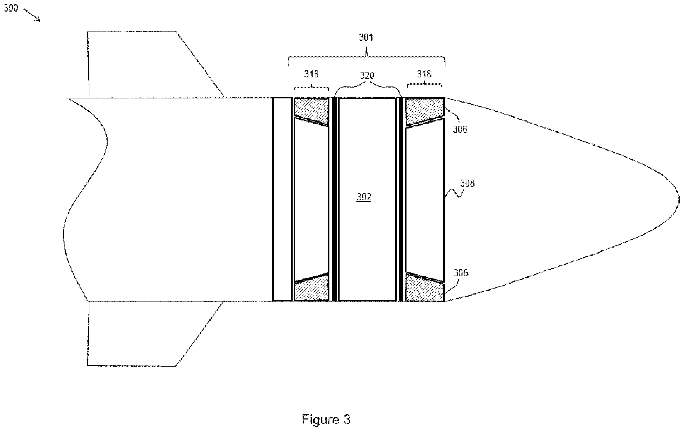

Turning to Figure 3, there is provided a missile 300 comprising an electronics unit 301, the electronics unit further comprising a housing (not shown) wherein the housing contains the potted electronics 302. The potted electronics 302 is held in an interference fit with the housing by two ramp arrangements 318 disposed either side of the potted electronics component 302. Each ramp arrangement comprises a first ramp 306 and a second ramp 308 slidably arranged against the first ramp 306. The electronics unit 301 further comprises a compressible membrane 320 disposed either side of the electronics component between the ramp arrangement 318 and the potted electronics unit 302. In this arrangement, the compressible membrane 320 is in the form of a rubber disc in order to further aide in the isolation of the potted electronics 302 within the housing. In this arrangement, the electronics unit 301 is a safe arm unit for the missile 300.

## Claims

1. An electronic unit for a missile comprising a potted electronics in a housing;
the unit being adapted to compensate for a difference in coefficient of thermal expansion between the potted electronics and the housing, the unit further comprising;
a first ramp; and,
a second ramp slidably arranged against the first ramp,
wherein the first and second ramps are disposed within the housing, the first or the second ramp abutting the potted electronics so as to provide an interference fit between the potted electronics and the housing;
wherein the first ramp and second ramp each comprise a coefficient of thermal expansion selected to maintain the interference fit between the potted electronics and the housing throughout a temperature range.

2. The unit according to claim 1 wherein the interface between the first and second ramp defines an angle, said interface configured to translate shocks along a longitudinal axis of the missile through the angle into the housing thereby isolating the potted electronics.

3. The unit according to any preceding claim wherein the first ramp is a toroid and the second ramp is cone shaped.

4. The unit according to claim 3 wherein the first and second ramp are concentrically arranged such that the toroid is slidaby mounted on the cone.

5. The unit according to any preceding claim wherein the temperature range is in the range of from -60°C to 100°C.

6. The unit according to any preceding claim wherein at least one of the first or second ramps is integral to the housing.

7. The unit according to any preceding claim wherein the potted electronics is potted in an epoxy compound.

8. The unit according to any preceding claim wherein the first ramp is made from a polymer.

9. The unit according to any preceding claim wherein the first ramp is made from polyoxymethylene.

10. The unit according to any preceding claim wherein the second ramp is made from aluminium.

11. The unit according to any preceding claim wherein the first or second ramp angle profile is tailored to ensure abutment of the first or second ramp to the potted electronics throughout the temperature range.

12. The unit according to any preceding claim wherein the unit further comprises a compressible membrane arranged between the first or second ramp and the potted electronics.

13. The unit according to any preceding claim wherein the first ramp comprises a coefficient of thermal expansion in the range of from 75 to 130 x 10⁻⁶*m*/*mK.*

14. The unit according to any preceding claim wherein the second ramp comprises a coefficient of thermal expansion in the range of from 10 to 30 x 10⁻⁶*m*/*mK.*

15. The unit of according to any preceding claim wherein the unit is a safe arm unit for a missile.

16. A missile comprising the unit of any preceding claim.

17. A method for designing an electronics unit according to any preceding claim comprising:
selecting coefficients of thermal expansion of the first and second ramps based upon the coefficient of thermal expansion of the potted electronics and
housing to ensure the first or second ramp abuts the potted electronics so as to provide the interference fit between the potted electronics and the housing throughout the temperature range.
